# EUROPEAN PATENT SPECIFICATION

(11) **EP 2 162 924 B1**
(45) Date of publication and mention of the grant of the patent: **14.08.2013**
(21) Application number: 08762623.0
(22) Date of filing: 30.06.2008
(51) Int. Cl.: H01L 31/0336, H01L 31/0352, H01L 31/18

(54) **SEMICONDUCTOR DEVICE STRUCTURE AND METHOD OF MANUFACTURE THEREOF**
HALBLEITERBAUELEMENTSTRUKTUR UND VERFAHREN ZU IHRER HERSTELLUNG
STRUCTURE DE DISPOSITIF SEMI-CONDUCTEUR ET PROCÉDÉ DE FABRICATION DE CELLE-CI

(30) Priority: 29.06.2007 GB 0712618
(43) Date of publication of application: 17.03.2010
(73) Proprietor: Kromek Limited, Sedgefield, Durham TS21 3FD (GB)
(72) Inventor: BASU, Arnab, Belmont, Durham DH1 2AW (GB); ROBINSON, Max, Shincliffe, Durham DH1 2LY (GB)
(74) Representative: Wilson, Peter
(86) International application number: PCT/GB2008/050521
(87) International publication number: WO 2009/004376

(56) References cited:
- WO-A1-2007/072023
- DE-A1- 2 813 671
- GB-A- 2 246 907
- JP-A- 61 214 462
- JP-A- 63 273 365
- US-A- 4 956 304
- US-A- 4 956 686
- US-A- 4 965 649
- US-B1- 6 180 967

## Description

The present invention relates to a semiconductor device and a method of manufacture thereof. In particular, the present invention relates to a device comprising a Group II-VI semiconductor material formed on a substrate of a dissimilar semiconductor material, and to a method for forming such a structure. In particular, the invention relates to a device for detection of a wide range of photon energies (gamma, x-ray and visible) and to a method of manufacture of the same.

Semiconductor materials are used in many applications, including electronic circuits and detectors. Different semiconductor materials may be especially suited for use in particular applications. For example, it is known to use Group II-VI materials such as cadmium telluride and cadmium zinc telluride (CZT) for detection of x-rays and gamma rays, since these materials are able to absorb photons and generate an electrical signal in response.

Single crystal materials in particular have a number of important applications. Bulk cadmium telluride (CdTe) and cadmium zinc telluride (CZT) single crystal semiconductors are useful for example as x-ray and gamma-ray detectors which have application in security screening, medical imaging and space exploration amongst other things.

For many applications, it is desired to have single crystals of large size and thickness, which can be formed rapidly with optimum uniformity and minimum impurities.

Where different semiconductor materials are required for different uses, it may also be useful to connect different semiconductor materials electrically together. For example, in the case of a detector, it is known to connect a semiconductor detector material to a semiconductor circuit using wire bonds or bump bonds. It can be difficult to form dissimilar single crystals into a coherent structure.

Traditionally, single crystals have been formed using direct solidification techniques, such as by the Bridgman, travelling heater (THM), gradient freeze (GF) or other liquid phase or self-seeding vapour phase crystal growth methods in which the crystals are grown from the melt. With these conventional methods, it has been difficult to form high quality crystals consistently, or to form single crystals having a diameter greater than 25 mm or 50 mm. In particular, with these known methods of crystal formation, dislocations, sub-grain boundaries and twins form easily. For high pressure Bridgman methods, there is also the potential problem of pipe formation.

These problems are particular problems when forming CdTe crystals. The inclusion of zinc to make CZT reduces these problems to some extent as the zinc strengthens the lattice. However zinc segregation at the solidification interface may result in graded axial compositional profiles. Moreover, higher temperatures are required for CZT growth, and this is undesirable. Also, the process tends to form precipitates and inclusions due to the excess tellurium in the melt. Telluride inclusions can be tens of microns in size and this may be significant for detector applications. Further, there will be a dislocation cloud associated with each inclusion which will affect the performance of detectors formed from the crystal.

In European Patent No EP-B-1019568 a method of forming crystals using a physical vapour phase technique is disclosed. This process is known as Multi-Tube Physical Vapour Phase Transport (MTPVT). According to this method, a sink or seed crystal of the material to be grown is provided. Vapour phase material is provided to the sink or seed crystal, causing nucleation and subsequent deposition of the material to grow the crystal onto the sink or seed crystal. The sink or seed crystal should be similar in material and structure to the crystal material to be grown, for example being only a doped or minor variation of the crystal composition. In particular, EP-B-1019568 discloses a method in which the sink or seed crystal is provided in a sink zone which is connected to a source zone via a passage able to transport vapour from the source zone to the sink zone. The temperature in the source and sink zones are controllable independently, the zones being thermally isolated.

The Multi-Tube Physical Vapour Phase Transport process disclosed in EP-B-1019568 is able to produce crystals of a more uniform and higher quality. However, a problem remains that the size of crystals that can be grown is limited as the crystal cannot be any larger than the seed crystal on which it is grown.

It is known to provide large substrates formed from materials such as silicon or gallium arsenide and to deposit a thin film of single crystal cadmium telluride or cadmium zinc telluride. The thin films can be deposited using thin film growth techniques such as molecular beam epitaxy, chemical vapour deposition, sputtering, metallo organic chemical vapour deposition (MOCVD), metal organic vapour phase epitaxy (MOVPE) and liquid phase epitaxy (LPE). These methods enable a single crystal thin film layer to be grown at rates of between 0.1 and 1 µm per hour, and therefore the thickness of the layer is very limited. Typically, the maximum thickness of such thin films is 1 to 10 µm. Although a thin film can be formed on a substrate to give a large area semiconductor crystal, such a film is not suitable for use as a detector for x-rays and gamma-rays. When detecting x-rays and gamma-rays, it is necessary to provide a sufficient thickness of material to stop the high energy photons. In order to capture 90% of the incident radiation at a photon energy of 100 keV, it is necessary for a CdTe layer to have a thickness of about 11 mm. Using typical methods for growing thin films, this would take around 10,000 hours. Therefore, suitable crystals cannot be grown using thin film deposition methods.

It is also known that screen printing techniques can be used to deposit a thick layer of material on a substrate, these layers are not single crystal layers, and therefore are unsuitable for detection of x-rays and gamma rays.

It had generally been considered that crystal mismatches between a substrate of a first bulk crystal material and a second bulk crystal material having different lattice structures would prevent the formation of the second bulk crystal material on such substrates, or would result in unacceptable stresses between the materials affecting the device unacceptably. For example, it was not generally considered possible to provide a cadmium telluride crystal material, which will have a lattice parameter a=6.481 Å (10 Å = 1 nm) directly onto a silicon substrate which will have a lattice parameter a=5.4309 Å due to the lattice mismatch. Accordingly, this limits the bulk crystal material that can be grown on any given substrate.

However, recent developments have suggested that the inclusion of an intermediate layer and transition region between the substrate and the bulk crystal material enables a gradual change in the crystal structure between the substrate and bulk crystal that can compensate for any mismatch in the lattice structure of the substrate and deposited crystal material and describes devices fabricated thereby, see e.g. WO 2007/072023 A1.

The invention relates to devices formed from heterostructures comprising a Group II-VI semiconductor material and another semiconductor material with enhanced functionality, especially when formed in accordance with the methods above described. The invention is defined by the terms of the claims.

Thus, in accordance with one aspect of the present invention there is provided a composite semiconductor device hetero structure according to claim 1, forming a hybrid detector device comprising a first bulk crystal semiconductor detector material, and a second bulk crystal semiconductor detector material, provided on a surface of the first bulk crystal semiconductor material, the second bulk crystal semiconductor material being a Group II-VI material comprising Cd_{1-(a+b)}MnₐZn_{b}Te where a and/or b may be zero, dissimilar to the first bulk crystal semiconductor material, the first bulk crystal material being a material for the detection of photons from a lower energy part of the spectrum than the second bulk crystal material, wherein portions of at least one of the bulk crystal materials and at least the second bulk crystal semiconductor material have reduced thickness selectively redotht to produce a patterned area of reduced thickness of the said bulk crystal semiconductor material. Preferably, said material is entirely removed to expose a patterned area of the surface of the other bulk crystal semiconductor material (or interfacial layer when present).

The second bulk crystal material may be formed directly upon the first. Optionally a deliberately formed interfacial region or layer may be present. The layer of second bulk crystal material is preferably formed on a first bulk crystal material and/ or on a deliberately formed interfacial region or layer as the case may be and/ or a deliberately formed interfacial region or layer is similarly preferably formed on a first bulk crystal material by a crystal growth process. This is likely to be preferable to the mere joining of layers by effectively attaching one slice of material to another. The fact that the materials are effectively joined in the solid state means that charge transfer is possible across the interface thus giving rise to a continuum of electrically selectable energy levels or bands across a wide spectral range.

The first and second crystal materials are formed as bulk crystal, and for example in either or both cases as a bulk single crystal (where bulk crystal in this context indicates a thickness of at least 500 µm, and preferably of at least 1 mm).

In accordance with the invention, a patterned structure is created by substantially reducing and in particular entirely removing at least one of the bulk crystal materials and the second bulk crystal semiconductor material within the patterned area. The resultant composite structure when considered through the thickness of the two layers thus presents patterned areas where a bulk structure of the first semiconductor material and a bulk structure of the second semiconductor material are present, and patterned areas where at least one of the materials is largely or entirely absent, and for example the surface of the other material is exposed where the one material is entirely absent. Different functionalities of the different regions can be exploited, and complex devices based on the different properties of the two semiconductors making up the composite structure can be developed.

Optionally, portions of both a first and a second bulk crystal material may be selectively removed.

Preferably, each bulk crystal material is a single crystal semiconductor structure.

The second bulk crystal material is a Group II-VI semiconductor comprising Cd_{1-(a+b)}MnₐZn_{b}Te where a and/or b may be zero. The first bulk crystal material comprises a different semiconductor, and in particular comprises a material which is not a Group II-VI semiconductor. For example, it is a Group III-V or Group IV semiconductor. It is further defined in terms of its ability to detect photons in claim 1.

In one possible embodiment, a deliberately formed interfacial layer may be provided between a first and second bulk material. Where present this should have a lattice structure compatible with the substrate formed by the first bulk crystal material. A suitable thickness is between 25 and 100 µm.

The interfacial intermediate layer may be of the same material or a different material from the second bulk crystal material.

Preferably, the deliberately formed interfacial layer in the interfacial region is formed from at least one film of a Group II-VI semiconductor material. In a particularly preferred application of the structure of the invention, the composite structure may be used as a detector for the detection of photons, and for example high-energy photons of x-rays or gamma rays. It is known that a number of Group II-VI semiconductors are effective in the detection of high-energy rays or gamma rays. Thus, in a composite device selectively patterned in accordance with the invention a selective functionality attributable to the Group II-VI semiconductor layer is achievable.

In a particularly preferred embodiment, the first bulk crystal semiconductor material is also a material suitable for the detection of photons and for example photons of x-rays or gamma rays either directly or indirectly. It is selected to detect photons across a different frequency band to that of the second bulk crystal where bulk is defined as thicker than 500 µm semiconductor material.

The resultant heterostructure comprises a hybrid detector device which can offer a wider detection spectrum than either of the materials making up the first or second semiconductors could on their own. Such an application requires that both the first and second materials comprise bulk crystal structures, and in particular bulk single crystal structures. Effective photon detection could not be achieved with practical results using thin film devices.

The second bulk crystal semiconductor material is a Group II-VI semiconductor material. Generally, this is suited to the detection of radiation at higher energies such as ionizing radiation, for example photons at the higher energy end of the spectrum such as the x-ray or gamma ray, or subatomic particle radiation. The second bulk crystal semiconductor material is selected from cadmium telluride, cadmium zinc telluride (CZT), cadmium manganese telluride (CMT), alloys thereof, and comprises crystalline Cd_{1-(a+b)}MnₐZn_{b}Te where a and/ or b may be zero.

The first bulk crystal semiconductor material is selected from a material suitable for detecting, either directly or indirectly, photons from a lower-energy part of the spectrum. For example, the first material is based on a Group III-V semiconductor, or a Group IV semiconductor. Typically, such semiconductors are more readily formed as an initial substrate layer as bulk crystal and in particular as bulk single crystal, and can be used to detect relatively lower-energy x-rays or visible light.

The Group II-VI material that is used as the second bulk crystal semiconductor material is selected from cadmium telluride, cadmium magnesium telluride, cadmium zinc telluride or similar semiconductor materials as defined in claim 1, and is suitable for detecting higher-energy x-rays/ gamma rays, and the first material is selected from silicon, silicon carbide, gallium arsenide, germanium, or similar semiconductor materials to give a detection of generally lower-energy x-rays. The combined heterostructure has an expanded effective detection spectrum.

Any suitable patterned structure may be formed within the second bulk crystal semiconductor having a regard to the desired application. For example, in particular in relation to detector applications, patterned potions of the second bulk semiconductor structure may be selectively removed in such manner as to create an effective pixellated array. The pixellated array structure may comprise a linear array, or a two dimensional array. In this way, complex patterned detectors can be created.

In accordance with the invention, the second bulk crystal semiconductor material is initially laid down as a single structure, and in particular a single crystal, on the first bulk semiconductor crystal material, and selectively patterned areas are then removed. Conveniently, as described in greater detail below, the selectively patterned areas are removed by a photolithographic technique. As will be understood, such a technique allows highly controlled and fine-scaled patterns to be incorporated into the composite heterostructure.

The two layer heterostructure is formed with or without a deliberately formed intermediate or interfacial layer laid down on the first material. Such a structure can assist in the formation of bulk crystal structures on a substrate from a material which differs from the material of the substrate on which they are formed, and in particular which have a different lattice structure from the underlying substrate. These composite layer materials may have better physical or structural properties than conventionally used materials, and they therefore have different applications. In particular, it may become easier to fabricate composite heterostructures in accordance with the invention in which a bulk crystal structure, and in particular a bulk single crystal structure, of a Group II-VI material defined by claim 1 is laid down onto a substrate of dissimilar material and patterned areas subsequently removed in accordance with the invention. For the envisaged applications, it is important that both the substrate and the second material are laid down as bulk crystals. A thin film second layer would not produce the desired functionality. It is preferable that the second material is formed on the substrate via a crystal growth process to maintain charge continuity across any interfacial or transition zone. Mere joining of layers is not likely to be so effective for this reason.

The structure may include a transition region in which there is a transition from the material of the deliberately formed intermediate or interfacial layer where present, or from the surface of the first bulk crystal layer itself where a deliberate interfacial layer is not present, to the second bulk crystal material. This may include a region of gradual change from the composition of the first material intermediate layer to that of the second bulk crystal material. The transition region may have a thickness of between 10 and 500 µm.

In a preferred example, the transition region and second bulk crystal can be deposited using the same growth technique, but with an initial variation in the growth parameters during the growth cycle to gradually change the composition and/or growth rate of the material deposited on the substrate. During the initial transition, the transition region is formed. After completing the change to the material of the bulk crystal to be deposited, the growth rate can be accelerated to rapidly deposit the bulk crystal material. In this case, it is preferred that a fabrication apparatus includes a means for introducing different source materials to be deposited onto the first bulk crystal material.

The intermediate layer where present can also be formed using the same technique as the transition region where present and the second bulk crystal layer.

The device structure according to the present invention can be formed using a number of techniques. It is preferred that one of the dissimilar semiconductor materials is provided as a substrate, onto which the interfacial region is deposited, and onto which the second semiconductor material is subsequently formed.

It is preferred that the second semiconductor material is deposited on the interfacial region using a bulk vapour deposition technique. It is preferred that the second semiconductor single crystal material is grown using a multi-tube physical vapour phase transport method, such as that disclosed in EP-B-1019568.

The second bulk layer may be deposited directly on the first without formation of a deliberate interfacial layer. Alternatively, one or more thin film interfacial layers can be formed using standard thin film deposition techniques. These include molecular beam epitaxy, chemical vapour deposition, sputtering, metallo organic chemical vapour deposition (MOCVD), metal organic vapour phase epitaxy and liquid phase epitaxy. Whilst all of these methods are relatively slow for, since the interfacial layer or layers are very thin, the growth rate of the layer is not of significant importance in the overall manufacturing process.

Alternatively, vapour phase deposition techniques can be used to grow the thin film interfacial layer or layers on the substrate. When vapour phase deposition techniques are conventionally used for bulk growth of crystal materials, the growth rate is typically between 100 and 500 µm/hour. In this case, it may be necessary for the growth to provide an underlying layer of the same material as that to be deposited. However, when the conditions are adjusted to grow a thin film at a growth rate of between 0.1 and 10 µm/hour, the thin film can be grown on a substrate of dissimilar material.

In addition to the first bulk crystal material, intermediate layer where present transition region where present and the second bulk crystal material, additional layers may be deposited. For example, a metal layer such as a layer of indium, platinum, gold or aluminium may be formed for electrical contact. Alternatively or additionally a dielectric layer may be provided. This is especially useful where the structure is to be used as a radiation detector as the dielectric layer may act as a filter to block visible and near infra red light.

In accordance with claim 10 of the present invention there is provided a method of forming a composite semiconductor device hetero structure comprising the steps of:
providing a first bulk crystal semiconductor material;
optionally forming an interfacial layer on a surface of the first bulk crystal semiconductor material;
forming a second bulk crystal semiconductor material of a Group II-VI material comprising crystalline Cd_{1-(a+b)}MnₐZn_{b}Te where a and/or b may be zero dissimilar to the first bulk crystal semiconductor material onto the interfacial layer;
selectively removing areas of at least one bulk crystal material, at least of the second bulk crystal semiconductor material to produce patterned areas of reduced thickness of removed material, and in particular to produce patterned areas where the surface of the other bulk crystal semiconductor material (or an interfacial layer if present) is exposed.

Optionally, portions of both a first and a second bulk crystal material are selectively removed.

Again, particularly for the envisaged applications, such as for use as photon detector, it is preferable if the first and/or second bulk crystal structures comprise single crystal structures. Again the layer of second bulk crystal material is desirably formed on a first bulk crystal material and/ or on an interfacial region or layer as the case may be by a crystal growth process.

In the preferred application, the Group II-VI material layer functions as a detector for high-energy photons. It requires a basic bulk crystal structure on at least a millimetre scale. For example, the layer is at least two millimetres thick. For the detection of gamma rays it is preferably at least one centimetre thick. However, once the structure is laid down, it is pixellated rather than planar in that the bulk crystalline material of the second layer is grown and then removed.

For example, the Group II-VI material is selected from the materials defined in claim 10, thus comprising cadmium telluride, cadmium magnesium telluride, cadmium zinc telluride or similar, or alloys thereof, and is suitable for detecting higher-energy x-rays/gamma rays, and the first material is selected from silicon, silicon carbide, gallium arsenide, germanium or similar semiconductor materials to give a detection of generally lower-energy x-rays. The combined heterostructure has an expanded effective detection spectrum.

The method provides that the second bulk crystal material is formed on a seed substrate of a first bulk crystal material different from the second crystal material to be formed. To enable the second crystal material to be formed on the substrate, an intermediate interfacial layer for example of a single crystal material may be first formed on the substrate, a transition region is further optionally formed on the intermediate layer and the second bulk single crystal material is grown on the intermediate layer and/or transition region by an appropriate vapour phase deposition method. The intermediate layer where present is generally a thin film layer.

In accordance with the method, a patterned structure is formed in at least one of the layers of bulk crystal material by substantial and preferably complete removal of material in patterned areas. Suitable patterned structures, for example comprising pixellated arrays, are discussed hereinabove. Any method for removing material once it has been deposited as a single bulk layer, and in particular as a single crystal layer, may be considered, being selected to be appropriate for the desired pattern structures. Generally, precise and small-scale patterns will be required. Generally, a physical or chemical etching process will be preferred.

In particular, patterned areas of the removed crystal material are removed using a photolithographic technique, wherein a suitable pattern is applied to the surface of the bulk crystal material to be removed, and selectively removed for example by suitable chemical etching. Specifically, as will be familiar, an e-m radiation sensitive photoresist is applied to a receptive surface of the bulk crystal material to be removed, a photo mask is applied including appropriate pattern features, the photoresist is exposed to radiation to develop it in the unmasked region, and a suitable chemical etch is applied to engrave the exposure pattern into the material underneath the exposed areas on the photoresist. Preferably, the exposed areas are substantially removed. If necessary, as will be familiar, this will be achieved by repeated cycles.

The method of the present invention allows a high quality bulk crystal structure of the second material to be formed quickly using physical vapour phase deposition methods on a substrate of the first material, enabling the required thickness of heterostructure to be formed in an acceptable time. The method provides the advantages associated with physical vapour phase deposition methods in terms of the speed of formation and quality of the crystal material, whilst allowing larger area crystals to be formed than is conventionally the case, and in particular, allowing the formation of heterostructures into which a pattern can be formed in at least the second layer.

Although one advantage of the present invention is the ability to produce large size heterostructures of bulk crystal materials for use in large detectors or the like, it is possible to divide the structure into smaller pieces. By producing a single, large piece of crystal heterostructure and then dividing this up into smaller pieces, it is considered possible to produce the required crystal material more quickly and with greater consistency than would be the case if the smaller pieces required were formed individually. A pattern may be developed into one or both layers before or after this dividing stage.

In one embodiment, an intermediate or interfacial layer is formed to accommodate crystal mismatch. The intermediate layer can be formed using standard thin film deposition techniques onto a substrate of the first bulk crystal material. These include molecular beam epitaxy, chemical vapour deposition, sputtering, metallo organic chemical vapour deposition (MOCVD), metal organic vapour phase epitaxy and liquid phase epitaxy. Whilst all of these methods are relatively slow, since the intermediate layer need only be very thin, the growth rate of the layer not of significant importance in the overall manufacturing process.

In an alternative embodiment, physical vapour phase deposition techniques are used to grow the thin film intermediate layer on a substrate of the first bulk crystal material. When vapour phase deposition techniques are used for growth of crystal materials, typically at a growth rate of between 100 and 500 µm/hour, it is necessary for the growth to provide an underlying layer of the same material as that to be deposited. However, when the conditions are adjusted to grow a thin film at a growth rate of between 1 and 10 µm/hour, the thin film can be grown on a foreign seed such as that provided by a receptive surface of the first bulk crystal material.

Optionally, a transition region is deposited immediately upon the intermediate layer where present, or immediately upon the surface of the first bulk crystal material. The optional transition region and second bulk crystal material can be deposited using the same growth technique, but with a variation in the growth parameters during the growth cycle to gradually accelerate the rate of growth. In particular, when the material is initially deposited onto a substrate, the growth rate will be slow, enabling the materials to be properly nucleated and formed. After depositing this initial material, the growth parameters can be changed to increase the rate of formation of the crystal material. Where the same technique is used to form the intermediate layer, there will be an initial region where the deposition changes from the slow, thin film type, deposition to the faster, bulk crystal, deposition. This change may be a gradual change, or may be an abrupt change.

In a preferred embodiment of the method the transition region where present and/or bulk crystal material is grown using a multi-tube physical vapour phase transport (MTPVT) method, such as that disclosed in EP-B-1019568.

The seed substrate comprises a first bulk crystal semiconductor material. This can be formed from various materials. However, preferred materials for these substrates are Group IV or Group III-V semiconductors such as silicon and gallium arsenide. An advantage of forming crystals on a silicon or gallium arsenide substrate is that these substrates have good mechanical strength. This both helps ensure that the second bulk crystal material is consistently formed on the substrate, and also helps maintain the integrity of the formed material in subsequent processing, use and transportation. For the preferred application, such materials are further advantageous as they may be used as radiation detectors, giving both layers of a structure this function.

The substrate may be of any size required, depending upon the required size of the crystal material. However, it is preferred that the substrate has a diameter greater than 25 mm, preferably greater than 50 mm, and most preferably at least 150 mm. The substrate can be as large as is available at the time.

The second bulk crystal material is a Group II-VI semiconductor which may include cadmium telluride and cadmium zinc telluride (CZT), cadmium manganese telluride (CMT), and similar semiconductor materials or combinations thereof as defined by claim 10. The material is for example Cd_{1-(a+b)}MnₐZn_{b}Te where a and/ or b may be zero.

The invention will now be described by way of example only with reference to Figure 1 to 3 of the accompanying claims in which:
Figure 1 shows a suitable multi-tube physical vapour phase transport device for growing structures according to the present invention;
Figure 2 shows a cross section of a material structure according to the present invention,
Figure 3 shows a cross section of a material structure according to the present invention.

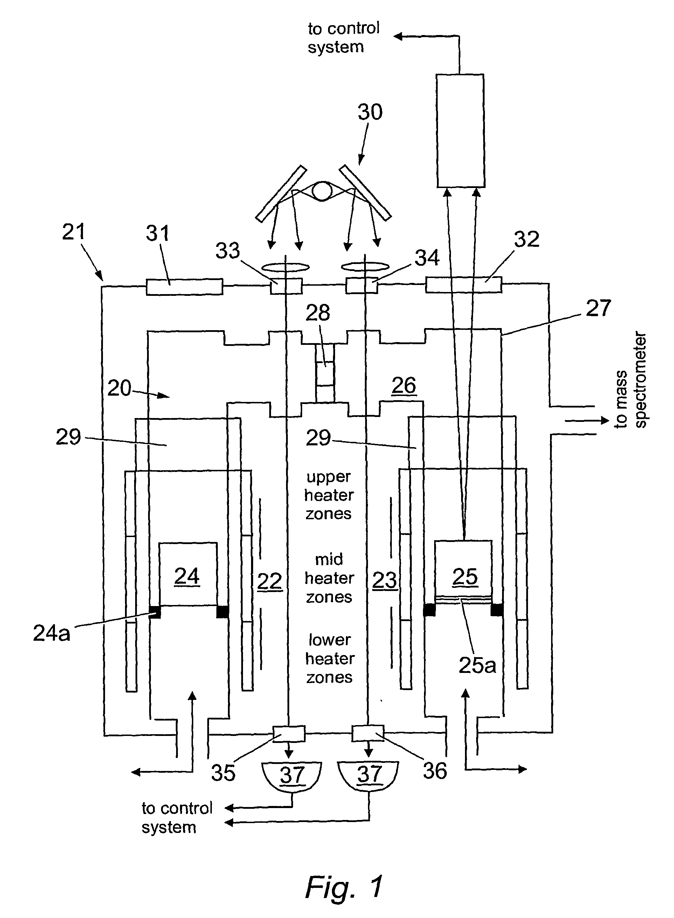

A preferred apparatus for the formation of a structure according to the present invention is shown in Figure 1. The apparatus is suitable for forming bulk single crystal materials of II-VI material on a bulk single crystal substrate of a dissimilar material. Generally bulk crystal materials will have a thickness of at least 500 µm.

The apparatus comprises an evacuated U-tube in the form of a quartz envelope 20 encased in a vacuum jacket 21. Two separate three zone vertical tubular furnaces are provided 22, 23 for the source 24 and the sink zone 25 respectively. The source zone is in communication with a gas inlet or pump in direction of the arrow, a flow restrictor 24a at the source allowing gas inlet. The sink zone is provided with a substrate support and downstream flow restrictor 25a and communicates to pump or vacuum jacket in direction of the arrow.

The source and sink zones are connected by an optically heated horizontal cross member 27 joined to them via the ground glass joints 29 forming a passage 26. A flow restrictor 28 is provided in the passage 26. The passage comprises two separate points of deviation - in each case at an angle of 90° - providing five respective junctions between diverging passages for in-situ monitoring and vapour transport from the source to the sink zone. Windows allowing optical access to source and sink respectively are provided.

The temperature of the surface of growing crystal in the sink zone can be monitored by a pyrometer or other optical diagnostic apparatus located external to the vacuum jacket and in optical communication with the surface of the growing crystal. The diagnostic apparatus is in communication with a suitable control system to vary the sink zone temperature. The apparatus also comprises means for in-situ monitoring of vapour pressure by access ports 33 to 36 in the region of the flow restrictor 28, through which vapour pressure monitoring lamps and optics 30 may be directed from a position external to the vacuum jacket with detectors 37 located as shown at a location adjacent access ports 35, 36 diametrically opposed with respect to the passage for vapour transport 26. These are suitably linked to a control system providing for process control.

The source tube, growth tube and crossmember, in which transport takes place, are fabricated from quartz and the system is demountable with ground glass joints 29 between the crossmember and the two vertical tubes allowing removal of grown crystals and replenishment of source material. Radiation shields (not shown for clarity) together with the vacuum jacket 21 which surrounds the entire system provide thermal insulation. A flow restrictor 28 such as a capillary or a sintered quartz disc is located in the centre of the passage 26 defined by the crossmember 27. Growth takes place on a substrate located on a quartz block in the growth tube with the gap between this glass block and the quartz envelope forming the downstream flow restrictor. Provision is made for a gas inlet to the source tube and the growth tube may be pumped by a separate pumping system or by connection to the vacuum jacket via a cool dump tube.

A number of additional source tubes may be provided. In this case, the additional source tubes can include different materials for deposition, and will include separate heaters.

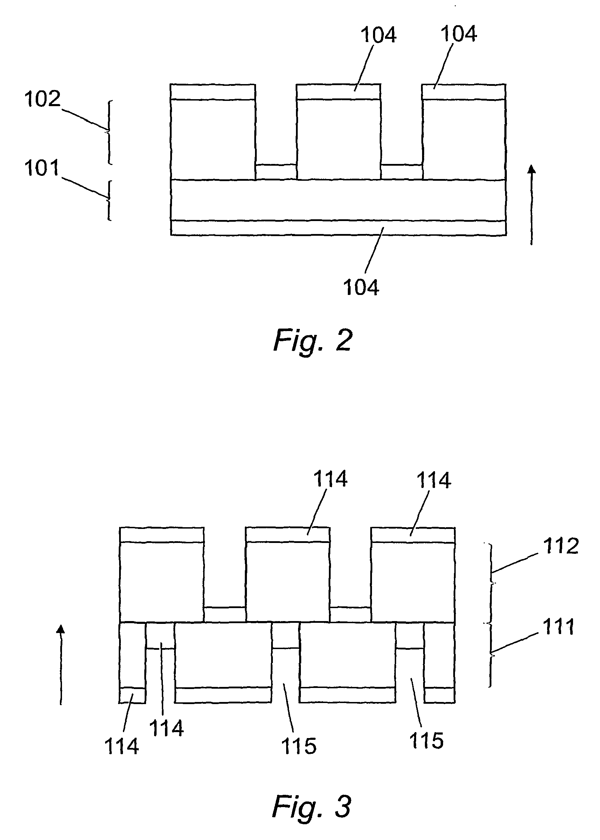

An example structure of a device according to the present invention is shown in Figure 2. The device is a heterostructure of a lower and higher energy photon detector.

Referring to Figure 2, an example heterostructure device for the detection of electromagnetic radiation in the x-ray/gamma ray spectrum is illustrated. In the particular embodiment, this has been prepared in accordance with the method and using the apparatus described with reference to Figure 1, although the structural aspect of the invention is not limited to a particular method of fabrication, and other suitable methods may suggest themselves to the skilled person.

The heterostructure device includes a gallium arsenide or silicon layer 101 which constitutes a first bulk crystal semiconductor material, and serves as a substrate for application of the method described with reference to Figure 1. The silicon/ GaAs layer may have a thickness greater than 100 µm, preferable of at least 200 µm for mechanical stability and can have any available size. In the intended application of the embodiment, the heterostructure device is a detector for electromagnetic radiation. A silicon layer is adapted to provide a detector for lower energy x-ray radiation or visible light. Its thickness may be selected accordingly.

As the skilled person will appreciate, gallium arsenide gives a different x-ray absorption profile, and in particular is likely to be useful for the detection of somewhat higher energy x-rays than is generally the case with silicon.

The structure includes a second layer 102 of a Group II-VI semiconductor material in accordance with the invention. The second layer optionally includes a deliberately formed thin film intermediate interfacial layer and/or transition region which is laid down first on the silicon substrate, for example in accordance with the forgoing method, and a bulk single crystal semiconductor layer which is developed thereupon. In accordance with the method, a source is selected so as to initially deposit an intermediate layer with the thickness of between 10 and 1000 µm, preferably in the region of a 100 to 700 µm. Typically, a thickness of 10 µm is sufficient for misfit dislocations to grow out. A thicker layer might help to ensure that any strain attributable to lattice mismatch will be primarily located in the substrate. After forming the optional transition layer, a bulk single crystal material can be deposited. If this is to be of different material, this might be achieved in accordance with the method of Figure 1 by changing the source material. In the embodiment, the entire layer of second material comprises cadmium telluride, cadmium zinc telluride or a mixture thereof, and the optional intermediate layer is not separately identified in the figure, and may not be specifically and identifiably distinct in the product.

The second layer 102 of CdTe/CZT is intended to act as a detector for high energy photons, and for example higher energy x-rays or gamma rays, than is the first layer. An appropriate thickness is selected accordingly. For example, for the detection of x-rays, the second layer is preferably at least 1 mm thick and more preferably at least 2 mm thick. For detection of gamma rays, the second layer is preferably at least 10 mm thick. This gives the resultant heterostructure an ability to detect incident radiation across a broader spectrum than either material is capable of alone.

The key to the invention is that once a layer of second bulk crystal material has been deposited on the substrate, areas are selectively removed to leave pattern regions comprising a one or two dimensional pixellated array of second material on the first material layer.

In a preferred mode of operation, a preferred radiation incident direction is illustrated by the arrow. Radiation is first incident upon the silicon layer, which detects lower energy x-rays in the usual manner. Higher energy x-rays/gamma rays pass through the silicon layer and are incident upon the pixellated CdTe/CZT structures in those regions where they are present. In these regions, a dual response is obtained, with the higher energy x-rays/gamma rays also being detected. In the regions where the second layer is absent, only the lower energy x-rays are detected. By selecting appropriate patterns, for example by employing a high precision photolithography technique which will be generally familiar, highly detailed pixellated arrangements can be developed in the second layer to exploit this functionality.

It will be apparent that the device would work in practice in relation to radiation incident from either direction.

To complete the structure in the illustrated embodiment, a passivating layer 103 is laid down on the silicon layer for protection, and electrode structures 104 are incorporated into the heterostructure.

Conveniently, the method of Figure 1 is used. The silicon substrate is first treated to remove any oxides. This treatment may include chemical etching or heating the substrate to a high temperature in an ultra high vacuum. The silicon substrate is provided in the growth chamber, with separate sources of zinc telluride and cadmium telluride. In accordance with embodiment an intermediate layer to serve as an interfacial layer is deliberately formed as a transition region. For some materials this may be desirable. In other instances a second bulk layer may be deposited directly.

The preferred temperature for the growth of the crystal material is around 700°C, and accordingly the temperature of the silicon substrate is increased to this temperature. The temperature of the zinc telluride and cadmium telluride sources is then increased at a rate of about 2°C per minute until the temperature of these reaches the same temperature as that of the substrate. Thereafter, the temperature of the cadmium telluride source is maintained at this level, whilst the temperature of the zinc telluride source is increased at the same rate to a temperature of around 870°C. When the zinc telluride source reaches a temperature of around 870°C, the temperatures of the substrate and source materials are maintained for around 5 hours. This causes the growth of an intermediate layer of zinc telluride to a thickness of around 50 µm on the substrate. Thereafter, the temperature of the substrate is maintained at around 700°C and the temperature of the zinc telluride source is maintained at around 870°C whilst the temperature of the cadmium telluride source is increased to the same temperature as the zinc telluride source material at a rate of around 2°C per minute. As the cadmium telluride material is heated, the material layer grown on the substrate will gradually change composition in a transition region from the zinc telluride material of the intermediate interface layer to a cadmium zinc telluride material with about 4% zinc. The resulting transition region will have a thickness of around 100 µm. The transition region could be reduced in thickness by increasing the rate of temperature increase of the cadmium telluride source, or could be made thicker by decreasing the rate of temperature increase. Thereafter, bulk crystal cadmium zinc telluride material will be deposited whilst the temperatures of the source materials are held at a higher temperature than the substrate. The precise composition of the deposited bulk crystal material can be controlled by varying the relative temperature of the two source materials.

In an alternative example, the intermediate layer is deposited on the upper surface of the seed plate by a conventional thin film deposition method. Suitable methods include molecular beam epitaxy, chemical vapour deposition, sputtering, metallo organic chemical vapour deposition (MOCVD), metal organic vapour phase epitaxy and liquid phase epitaxy methods. The thin film layer of the required crystal material is deposited or grown on the substrate at a typical rate of between 0.1 and 10 µm per hour, although could be greater. However, only a very thin layer is required to be formed on the upper surface of the substrate, typically having a thickness of between about 1 and 10 µm, although could be greater. The film thickness should be at least 1 µm to ensure that the layer is fully relaxed. The maximum thickness of the layer is preferably 10 µm so that the layer can be formed within an acceptable time.

After forming the thin film on the upper surface of the substrate, the substrate is removed from the growth chamber, and is treated, for example being cleaned and polished. The substrate is then provided for the growth of the transition region and the bulk crystal material using a physical vapour phase method.

Figure 3 shows an alternative heterostructure device prepared in accordance with the same principles as Figure 2. Again, a base layer 111 is provided of gallium arsenide or silicon on which is deposited a second layer 112 of CdTe/CZT.

A patterned structure is again developed in the upper layer, by removal of selected areas to leave structures in a suitable pattern, and for example forming a pixellated array. However, in this instance a pattern 115 is also developed in the Si or GaAs layer. The heterostructure device is completed in like manner to that of Figure 2 by the provision of passivating layers in the areas where silicon or gallium arsenide semiconductor is exposed, and the incorporation of electrodes 114.

The transitional region will typically be very small compared to the substrate and bulk crystal material, and therefore the effects are considered negligible in the overall device.

Examples of possible structures, giving the bulk first crystal material, intermediate layer and bulk second crystal material are set out in table 1 below.

**Table 1: Examples of possible structures**

| Example | First Bulk Crystal Material | Intermediate Layer + trace elements | Second Bulk Crystal Material | Overall Structure |
|---|---|---|---|---|
| 1 | Si | CdTe | CdTe | Si : CdTe : CdTe |
| 2 | Si | CZT | CZT | Si : CZT : CZT |
| 3 | Si | CZT | CdTe | Si : CZT : CdTe |
| 4 | Si | CdTe | CZT | Si : CdTe : CZT |
| 5 | Si | CdMnTe | CdMnTe | Si:CdMnTe:CdMnTe |
| 6 | Si | 0 | CdTe | Si: CdTe |
| 7 | Si | 0 | CZT | Si: CZT |
| 8 | Si | 0 | CdMnTe | Si : CdMnTe |
| 9 | GaAs | CdTe | CdTe | GaAs : CdTe : CdTe |
| 10 | GaAs | CZT | CZT | GaAs : CZT : CZT |
| 11 | GaAs | CZT | CdTe | GaAs : CZT : CdTe |
| 12 | GaAs | CdTe | CZT | GaAs : CdTe : CZT |
| 13 | GaAs | CdMnTe | CdMnTe | GaAs: CdMnTe: CdmTe |
| 14 | GaAs | 0 | CdMnTe | GaAs : CdMnTe |
| 15 | GaAs | 0 | CdTe | GaAs : CdTe |
| 16 | GaAs | 0 | CZT | GaAs : CZT |
| 17 | Ge | CdTe | CdTe | Ge : CdTe : CdTe |
| 18 | Ge | CZT | CZT | Ge : CZT : CZT |
| 19 | Ge | CZT | CdTe | Ge : CZT : CdTe |
| 20 | Ge | CdTe | CZT | Ge : CdTe : CZT |
| 21 | Ge | CdMnTe | CdMnTe | Ge:CdMnTe:CdMnTe |
| 22 | Ge | 0 | CZT | Ge : CZT |
| 23 | Ge | 0 | CdTe | Ge : CdTe |
| 24 | Ge | 0 | CdMnTe | Ge : CdMnTe |
| 25 | Silicon Carbide | CdTe | CdTe | Silicon Carbide: CdTe: CdTe |
| 26 | Silicon Carbide | CZT | CZT | Silicon Carbide : CZT: CZT |
| 27 | Silicon Carbide | CZT | CdTe | Silicon Carbide: CZT: CdTe |
| 28 | Silicon Carbide | CdTe | CZT | Silicon Carbide: CdTe: ZT |
| 29 | SiC | CdS | CdTe | SiC : CdS : CdTe |
| 30 | SiC | Cds | CZT | SiC : CdS : CZT |
| 31 | SiC | CdMnTe | CdMnTe | SiC:CdMnTe:CdMnTe |
| 32 | SiC | 0 | CdMnTe | SiC : CdMnTe |
| 33 | SiC | 0 | CdTe | SiC : CdTe |
| 34 | SiC | 0 | CZT | SiC : CZT |

One particular advantage of devices made in accordance with the present invention is that the different materials used to form the substrate, intermediate layer and bulk crystal material may provide different functions in the final device. For example, in the example embodiments of a silicon or GaAs substrate, cadmium telluride bulk crystal material, the cadmium telluride material may be used to detect high-energy photons, whilst the silicon or GaAs substrate may be able to detect lower energy photons.

Where, as in the preferred embodiment, the material is to be used for detection of radiation, the required thickness of the material will be dependent upon the energy to be absorbed. For cadmium telluride, cadmium zinc telluride and cadmium manganese telluride, the thickness of material required for absorption of radiation of various energies is as set out in Table 2 below.

**Table 2 - thickness of material required for varied energy**

| Photon Energy | Thickness required for 50% absorption |
|---|---|
| 50keV | 0.007 cm |
| 100 keV | 0.07 cm |
| 200 keV | 0.35 cm |
| 500 keV | 1.2 cm |
| 750 keV | 1.7 cm |
| 1-10MeV | 2. 3 -3. 5 cm |

## Claims

1. A composite semiconductor device heterostructure forming a hybrid detector device comprising a first bulk crystal semiconductor detector material (101, 111) suitable for the detection of photons from a lower-energy part of the electromagnetic spectrum, and second bulk crystal semiconductor detector material (102, 112) suitable for the detection of photons from a higher-energy part of the electromagnetic spectrum provided on a surface of the first bulk crystal semiconductor material, the second bulk crystal semiconductor detector material being a Group II-VI material comprising crystalline Cd_{1-(a+b)}MnₐZn_{b}Te where a and/ or b may be zero dissimilar to the first bulk crystal semiconductor material, the first bulk crystal semiconductor detector material (101, 111) being a material for the detection of photons from a lower energy part of the spectrum than the second bulk crystal material wherein portions of at least the second bulk crystal semiconductor material have selectively reduced thickness to produce a patterned area of reduced thickness of the said bulk crystal semiconductor material

2. A structure according to claim 1 wherein portions of a first and of a second bulk crystal semiconductor detector material have selectively reduced thickness.

3. A structure according to claim 1 or claim 2 wherein portions of at least one bulk crystal semiconductor material have thickness reduced to zero such that said composite semiconductor device structure is divided into portions of said at least one bulk crystal semiconductor material separated by exposed portions, those exposed portions exposing the surface of the other crystal semiconductor material.

4. A structure according to any one of the preceding claims wherein patterned portions of the patterned bulk semiconductor structure are structured in such manner as to create an effective pixellated array, for example a linear array or area array.

5. A structure according to any one of the preceding claims, in which the first bulk crystal material (101, 111) comprises a semiconductor material which is not a Group II-VI semiconductor.

6. A structure according to claim 5, in which the first bulk crystal material (101, 111) comprises a substrate of silicon, gallium arsenide, silicon carbide or germanium.

7. A structure according to any one of the preceding claims, in which the first bulk crystal material (101, 111) has a thickness of at least 100 µm, preferably at least 200 µm.

8. A structure according to any one of the preceding claims, in which the second bulk crystal material (102, 112) has a thickness of at least 0.5 mm, preferably at least 10 mm.

9. A structure according to any one of the preceding claims wherein the first and/or second bulk crystal is a single crystal.

10. A method of forming a composite semiconductor device heterostructure forming a hybrid detector device comprising the steps of:
providing a first bulk crystal semiconductor detector material (101, 111) suitable for the detection of photons from a lower-energy part of the electromagnetic spectrum the first bulk crystal semiconductor detector material (101, 111) being a material for the detection of photons from a lower energy part of the spectrum than the second bulk crystal material;
optionally forming an interfacial layer on a surface of the first bulk crystal semiconductor material;
forming a second bulk crystal semiconductor detector material (102, 112) suitable for the detection of photons from a higher-energy part of the electromagnetic spectrum of a Group II-VI material comprising crystalline Cd_{1-(a+b)}Mnₐzn_{b}Te where a and/ or b may be zero dissimilar to the first bulk crystal semiconductor material thereon;
selectively removing areas of at least the second bulk crystal semiconductor material to produce patterned areas of reduced thickness of the removed material.

11. The method according to claim 10 wherein portions of at least one bulk semiconductor material are removed entirely, resulting in a reduced thickness of zero, so that the material is entirely absent and said composite semiconductor device structure is divided into portions of said at least one bulk crystal semiconductor material separated by exposed portions, those exposed portions exposing the surface of the other crystal semiconductor material.

12. The method according to claim 10 or 11 wherein material is removed to form a pixellated array, for example a linear array or area array.

13. The method according to anyone of claims 10 to 12 wherein material is removed by a photolithographic method.

14. The method according to claim 13 wherein an electro-magnetic (em) radiation sensitive photoresist is applied to a receptive surface of the bulk crystal material to be removed, a photo mask is applied including appropriate pattern features, the photoresist is exposed to radiation to develop it in the unmasked region, and a suitable chemical etch is applied to engrave the exposure pattern into the bulk crystal material underneath the exposed areas on the photoresist.

15. The method according to any one of claims 10 to 14, in which the first bulk crystal material (101, 111) is a silicon, gallium arsenide, silicon carbide or germanium substrate.

## Patentansprüche

1. Eine Verbundhalbleitervorrichtungsheterostruktur, die eine hybride Detektorvorrichtung bildet, beinhaltend ein erstes Bulkkristall-Halbleiterdetektormaterial (101, 111), das zur Detektion von Photonen von einem Teil des elektromagnetischen Spektrums mit niedrigerer Energie geeignet ist, und ein zweites Bulkkristall-Halbleiterdetektormaterial (102, 112), das zur Detektion von Photonen von einem Teil des elektromagnetischen Spektrums mit höherer Energie geeignet ist, bereitgestellt auf einer Oberfläche des ersten Bulkkristall-Halbleitermaterials, wobei das zweite Bulkkristall-Halbleiterdetektormaterial ein Material der Gruppe II-VI ist, beinhaltend kristallines Cd_{1-(a+b)} MnₐZn_{b}Te, wobei a und/oder b Null sein können, verschieden vom ersten Bulkkristall-Halbleitermaterial, wobei das erste Bulkkristall-Halbleiterdetektormaterial (101, 111) ein Material zur Detektion von Photonen von einem Teil des Spektrums mit niedrigerer Energie ist als das zweite Bulkkristallmaterial, wobei Abschnitte von mindestens dem zweiten Bulkkristall-Halbleitermaterial eine selektiv reduzierte Dicke aufweisen, um ein gemustertes Feld reduzierter Dicke des Bulkkristall-Halbleitermaterials zu erzeugen.

2. Struktur gemäß Anspruch 1, wobei Abschnitte eines ersten und eines zweiten Bulkkristall-Halbleiterdetektormaterials eine selektiv reduzierte Dicke aufweisen.

3. Struktur gemäß Anspruch 1 oder Anspruch 2, wobei Abschnitte von mindestens einem Bulkkristall-Halbleitermaterial eine auf Null reduzierte Dicke aufweisen, so dass die Verbundhalbleitervorrichtungsstruktur in Abschnitte des mindestens einen Bulkkristall-Halbleitermaterials, das durch freigelegte Abschnitte getrennt ist, unterteilt wird, wobei jene freigelegten Abschnitte die Oberfläche des anderen Kristall-Halbleitermaterials freilegen.

4. Struktur gemäß einem der vorhergehenden Ansprüche, wobei gemusterte Abschnitte der gemusterten Bulk-Halbleiterstruktur derart strukturiert sind, dass sie eine wirksame verpixelte Anordnung schaffen, zum Beispiel eine lineare Anordnung oder Feld-Anordnung.

5. Struktur gemäß einem der vorhergehenden Ansprüche, wobei das erste Bulkkristallmaterial (101, 111) ein Halbleitermaterial beinhaltet, das kein Halbleiter der Gruppe-II-VI ist.

6. Struktur gemäß Anspruch 5, wobei das erste Bulkkristallmaterial (101, 111) ein Substrat aus Silizium, Galliumarsenid, Siliziumkarbid oder Germanium beinhaltet.

7. Struktur gemäß einem der vorhergehenden Ansprüche, wobei das erste Bulkkristallmaterial (101, 111) eine Dicke von mindestens 100 µm, bevorzugt von mindestens 200 µm, aufweist.

8. Struktur gemäß einem der vorhergehenden Ansprüche, wobei das zweite Bulkkristallmaterial (102, 112) eine Dicke von mindestens 0,5 mm, bevorzugt von mindestens 10 mm, aufweist.

9. Struktur gemäß einem der vorhergehenden Ansprüche, wobei der erste und/oder zweite Bulkkristall ein Einkristall ist.

10. Ein Verfahren zum Bilden einer Verbundhalbleitervorrichtungsheterostruktur, die eine hybride Detektorvorrichtung bildet, beinhaltend die folgenden Schritte:
Bereitstellen eines ersten Bulkkristall-Halbleiterdetektormaterials (101, 111), das zur Detektion von Photonen von einem Teil des elektromagnetischen Spektrums mit niedrigerer Energie geeignet ist, wobei das erste Bulkkristall-Halbleiterdetektormaterial (101, 111) ein Material zur Detektion von Photonen von einem Teil des elektromagnetischen Spektrums mit niedrigerer Energie ist als das zweite Bulkkristallmaterial;
optional Bilden einer Grenzflächenschicht auf einer Oberfläche des ersten Bulkkristall-Halbleitermaterials;
Bilden eines zweiten Bulkkristall-Halbleiterdetektormaterials (102, 112), das zur Detektion von Photonen von einem Teil des elektromagnetischen Spektrums mit höherer Energie geeignet ist, von einem Material der Gruppe II-VI, beinhaltend kristallines Cd_{1-(a+b)}MnₐZn_{b}Te, wobei a und/oder b Null sein können, verschieden vom ersten Bulkkristall-Halbleitermaterial darauf;
selektives Entfernen von Feldern von mindestens dem zweiten Bulkkristall-Halbleitermaterial, um gemusterte Felder reduzierter Dicke des entfernten Materials zu erzeugen.

11. Verfahren gemäß Anspruch 10, wobei Abschnitte von mindestens einem Bulk-Halbleitermaterial vollständig entfernt werden, was zu einer reduzierten Dicke von Null führt, so dass das Material vollständig fehlt und die Verbundhalbleitervorrichtungsstruktur in Abschnitte von mindestens dem einen Bulkkristall-Halbleitermaterial, das durch freigelegte Abschnitte getrennt ist, unterteilt wird, wobei jene freigelegten Abschnitte die Oberfläche des anderen Kristall-Halbleitermaterials freilegen.

12. Verfahren gemäß Anspruch 10 oder 11, wobei Material entfernt wird, um eine verpixelte Anordnung zu bilden, zum Beispiel eine lineare Anordnung oder eine Feld-Anordnung.

13. Verfahren gemäß einem der Ansprüche 10 bis 12, wobei Material durch ein fotolithografisches Verfahren entfernt wird.

14. Verfahren gemäß Anspruch 13, wobei ein auf elektromagnetische Strahlung (EM-Strahlung) empfindlicher Photoresist auf eine aufnahmefähige Oberfläche des zu entfernenden Bulkkristallmaterials angewendet wird, eine Photomaske angewendet wird, einschließlich entsprechender Mustermerkmale, der Photoresist mit Strahlung belichtet wird, um ihn in dem unmaskierten Bereich zu entwickeln, und ein geeignetes chemisches Ätzen angewendet wird, um das Belichtungsmuster in das Bulkkristallmaterial unterhalb der freigelegten Felder auf dem Photoresist einzugravieren.

15. Verfahren gemäß einem der Ansprüche 10 bis 14, wobei das erste Bulkkristallmaterial (101, 111) ein Silizium, Galliumarsenid, Siliziumkarbid oder Germanium-Substrat ist

## Revendications

1. Une hétérostructure de dispositif semi-conducteur composite formant un dispositif détecteur hybride comprenant un premier matériau de détecteur semiconducteur en cristal massif (101, 111) adéquat pour la détection de photons provenant d'une partie de plus faible énergie du spectre électromagnétique, et un deuxième matériau de détecteur semiconducteur en cristal massif (102, 112) adéquat pour la détection de photons provenant d'une partie de plus haute énergie du spectre électromagnétique fourni sur une surface du premier matériau semiconducteur en cristal massif, le deuxième matériau de détecteur semiconducteur en cristal massif étant un matériau des Groupes II à VI comprenant du Cd_{1-(a+b)}MnₐZn_{b}Te cristallin où a et/ou b peuvent être zéro, différent du premier matériau semiconducteur en cristal massif, le premier matériau de détecteur semiconducteur en cristal massif (101, 111) étant un matériau destiné à la détection de photons provenant d'une partie de plus faible énergie du spectre que le deuxième matériau en cristal massif, dans laquelle des portions du deuxième matériau semiconducteur en cristal massif au moins sont d'épaisseur réduite sélectivement afin de produire une section conformée selon un motif d'épaisseur réduite dudit matériau semiconducteur en cristal massif.

2. Une structure selon la revendication 1 dans laquelle des portions d'un premier et d'un deuxième matériau de détecteur semiconducteur en cristal massif sont d'épaisseur réduite sélectivement.

3. Une structure selon la revendication 1 ou la revendication 2 dans laquelle des portions d'au moins un matériau semiconducteur en cristal massif sont d'épaisseur réduite à zéro, de telle sorte que ladite structure de dispositif semiconducteur composite est divisée en portions dudit au moins un matériau semiconducteur en cristal massif séparées par des portions exposées, ces portions exposées exposant la surface de l'autre matériau semiconducteur en cristal.

4. Une structure selon l'une quelconque des revendications précédentes dans laquelle des portions conformées selon un motif de la structure en semiconducteurs massifs conformés selon un motif sont structurées de manière telle à créer un arrangement pixelisé effectif, par exemple un arrangement linéaire ou un arrangement matriciel.

5. Une structure selon l'une quelconque des revendications précédentes, dans laquelle le premier matériau en cristal massif (101, 111) comprend un matériau semiconducteur qui n'est pas un semiconducteur des Groupes II à VI.

6. Une structure selon la revendication 5, dans laquelle le premier matériau en cristal massif (101, 111) comprend un substrat en silicium, arséniure de gallium, carbure de silicium ou germanium.

7. Une structure selon l'une quelconque des revendications précédentes, dans laquelle le premier matériau en cristal massif (101, 111) a une épaisseur d'au moins 100 µm, de préférence d'au moins 200 µm.

8. Une structure selon l'une quelconque des revendications précédentes, dans laquelle le deuxième matériau en cristal massif (102, 112) a une épaisseur d'au moins 0,5 mm, de préférence d'au moins 10 mm.

9. Une structure selon l'une quelconque des revendications précédentes, dans laquelle le premier et/ou le deuxième cristal massif est un monocristal.

10. Une méthode de formation d'une hétérostructure de dispositif semiconducteur composite formant un dispositif détecteur hybride comprenant les étapes consistant à :
fournir un premier matériau de détecteur semiconducteur en cristal massif (101, 111) adéquat pour la détection de photons provenant d'une partie de plus faible énergie du spectre électromagnétique, le premier matériau de détecteur semiconducteur en cristal massif (101, 111) étant un matériau destiné à la détection de photons provenant d'une partie de plus faible énergie du spectre que le deuxième matériau en cristal massif ;
former de manière facultative une couche interfaciale sur une surface du premier matériau semiconducteur en cristal massif ;
former un deuxième matériau de détecteur semiconducteur en cristal massif (102, 112) adéquat pour la détection de photons provenant d'une partie de plus haute énergie du spectre électromagnétique en un matériau des Groupes II à VI comprenant du Cd_{1-(a+b)} MnₐZn_{b}Te cristallin où a et/ou b peuvent être zéro, différent du premier matériau semiconducteur en cristal massif, sur celle-ci ;
retirer de manière sélective des sections du deuxième matériau semiconducteur en cristal massif au moins afin de produire des sections conformées selon un motif d'épaisseur réduite du matériau retiré.

11. La méthode selon la revendication 10, dans laquelle des portions d'au moins un matériau semiconducteur massif sont totalement retirées, avec pour résultat une épaisseur réduite qui est de zéro, de sorte que le matériau est totalement absent et que ladite structure de dispositif semiconducteur composite est divisée en portions dudit au moins un matériau semiconducteur en cristal massif séparées par des portions exposées, ces portions exposées exposant la surface de l'autre matériau semiconducteur en cristal.

12. La méthode selon la revendication 10 ou la revendication 11, dans laquelle il est retiré du matériau pour former un arrangement pixelisé, par exemple un arrangement linéaire ou un arrangement matriciel.

13. La méthode selon l'une quelconque des revendications 10 à 12 dans laquelle il est retiré du matériau grâce à une méthode photolithographique.

14. La méthode selon la revendication 13, dans laquelle il est appliqué une photorésine sensible au rayonnement électromagnétique (e-m) sur une surface réceptrice du matériau en cristal massif à retirer, il est appliqué un photomasque incluant des caractéristiques de motif appropriées, la photorésine est exposée au rayonnement afin de la développer dans la région non masquée, et il est appliqué un décapage chimique adéquat pour graver le motif d'exposition dans le matériau en cristal massif sous les sections exposées sur la photorésine.

15. La méthode selon l'une quelconque des revendications 10 à 14, dans laquelle le premier matériau en cristal massif (101, 111) est un substrat en silicium, arséniure de gallium, carbure de silicium ou germanium.
